(19) Europäisches Patentamt
European Patent Office
Office européen des brevets

(11) **EP 2 133 997 A1**

(12) **EUROPÄISCHE PATENTANMELDUNG**

(43) Veröffentlichungstag:
16.12.2009 Patentblatt 2009/51

(51) Int Cl.:
*H03K 17/96* (2006.01)     *H03K 17/18* (2006.01)

(21) Anmeldenummer: 09100333.5

(22) Anmeldetag: 12.06.2009

(84) Benannte Vertragsstaaten:
AT BE BG CH CY CZ DE DK EE ES FI FR GB GR HR HU IE IS IT LI LT LU LV MC MK MT NL NO PL PT RO SE SI SK TR

(30) Priorität: 13.06.2008 DE 102008028313

(71) Anmelder: BSH Bosch und Siemens Hausgeräte GmbH
81739 München (DE)

(72) Erfinder: Redelstab, Markus
76135, Karlsruhe (DE)

(54) **Kapazitiver Berührungsschalter für ein Haushaltsgerät**

(57) Die Erfindung betrifft einen kapazitiver Berührungsschalter für ein Haushaltsgerät, mit einer Bedienblende (2) zur berührsensitiven Betätigung des Berührungsschalters (7, 8) über eine Oberflächenberührung (3) der Bedienblende (2), und mit einer Elektrode, die in einem Abstand hinter der Bedienblende (2) angeordnet ist.

Zwischen der Bedienblende (2) und der Elektrode ist ein aus einem dielektrischen und elektrisch isolierenden Material ausgebildetes Element (6, 9) angeordnet, welches den Abstand zwischen der Bedienblende (2) und der Elektrode überbrückt. Die Erfindung betrifft auch eine Bedieneinrichtung für ein Haushaltsgerät mit zumindest einem kapazitiven Berührungsschalter und ein Haushaltsgerät mit solch einer Bedieneinrichtung.

Figur

EP 2 133 997 A1

**Beschreibung**

Die Erfindung betrifft einen kapazitiven Berührungsschalter für ein Haushaltsgerät, mit einer Bedienblende zur berührsensitiven Betätigung des Berührungsschalters über eine Oberflächenberührung der Bedienblende, und mit einer Elektrode, die in einem Abstand hinter der Bedienblende angeordnet ist.

Aus der EP 0 859 467 A1 ist ein Berührungsschalter mit einer Sensortaste bekannt. Die Sensortaste weist einen in sich flexiblen, räumlich ausgedehnten, raumformveränderlichen und elektrisch leitfähigen Körper auf, welcher beispielsweise als elektrisch leitender Schaumstoff ausgebildet sein kann. Dieser Körper ist zwischen einer Elektrode einer Platine und einer Glaskeramikplatte eines Kochfelds angeordnet.

Des Weiteren ist aus der DE 10 2005 008 758 A1 ein kapazitiver Annäherungs- und/oder Berührungsschalter bekannt. Bei diesem Schalter ist zwischen einer elektrisch isolierenden Abdeckplatte und in einem Abstand von dieser angeordneten Trägerplatte eine elektrisch leitfähige Druckfeder angeordnet.

Es ist Aufgabe der vorliegenden Erfindung, einen kostengünstigen, kapazitiven Berührungsschalter für ein Haushaltsgerät zu schaffen.

Diese Aufgabe wird durch einen Berührungsschalter mit den Merkmalen des Anspruchs 1 gelöst.

Im folgenden wird unter einem Haushaltsgerät ein Gerät verstanden, das zur Haushaltsführung eingesetzt wird. Das kann ein Haushaltsgroßgerät sein, wie beispielsweise eine Waschmaschine, ein Wäschetrockner, eine Geschirrspülmaschine, ein Gargerät, eine Dunstabzugshaube, ein Kältegerät oder ein Klimagerät. Das kann aber auch ein Haushaltskleingerät sein, wie beispielsweise ein Warmwasserbereiter, ein Kaffeeautomat, eine Küchenmaschine oder ein Staubsauger.

Unter einem Berührungsschalter wird ein Eingabeelement verstanden, bei dem eine Berührung als Betätigung mittels Sensorik detektiert wird, ohne das eine mechanische Bewegung eines Schaltelements durchgeführt wird. D.h. Bedienblenden, bei denen solche Berührungsschalter als Eingabeelemente eingesetzt sind, können ohne Durchbruch mit einer geschlossen Oberfläche ausgebildet sein. Dies hat insbesondere bei Haushaltsgeräten den Vorteil, dass Verschmutzungen solch einer geschlossenen Oberfläche leicht beseitigt werden können und Verunreinigungen durch solch eine geschlossenen Bedienblende nicht in den Geräteinnenraum eintreten können.

Ein erfindungsgemäßer kapazitiver Berührungsschalter für ein Haushaltsgerät umfasst eine Bedienblende zur berührsensitiven Betätigung des Berührungsschalters über eine Oberflächenberührung der Bedienblende, und weist darüber hinaus zumindest eine Elektrode auf, die in einem Abstand hinter der Bedienblende angeordnet ist. Zwischen der Bedienblende und der Elektrode ist ein aus einem dielektrischen und elektrisch isolierenden Material ausgebildetes Element angeordnet. Die Elektrode ist mit einer Auswerteelektronik verbunden. Die Elektrode ist auf einem Träger angeordnet. Vorzugsweise ist die Elektrode zusammen mit der Auswerteelektronik auf einem gemeinsamen Träger angeordnet, der insbesondere eine Leiterplatte sein kann. Durch die Ausgestaltung des kapazitiven Berührungsschalters mit dem dielektrischen, elektrisch isolierendem Element, welches den Abstand zwischen der Rückseite der Bedienblende und der Elektrode überbrückt, kann ein im Vergleich zu leitenden Komponenten anderweitig gelagertes kapazitives Sensorprinzip realisiert werden, welches darüber hinaus sehr bauraumminimiert und kompakt aufgebaut werden kann. Darüber hinaus kann der Berührungsschalter sehr funktionszuverlässig gestaltet werden und es ist eine flexible Überwindung der Distanz zwischen der Elektrode der Auswerteelektronik und der Bedienoberfläche bei räumlich möglichst naher und direkter Ankopplung des elektrischen Felds an die Oberfläche der Bedienblende möglich.

Bei dem vorliegenden, kapazitiven Berührungsschalter bilden die Elektrode und der Finger eines Benutzers bei Berührung der Bedienblende die Platten eines Kondensators. Die Kapazität C dieses Kondensators ist proportional zu dem Produkt aus Dielektrizitätskonstante des Vakuums $\varepsilon_0$, Dielektrizitätskonstante des Materials zwischen den Kondensatorplatten $\varepsilon_r$ und Fläche der Kondensatorplatten A dividiert durch den Abstand der Kondensatorplatten d:

$$C = \varepsilon_0 \cdot \varepsilon_r \cdot A/d$$

Durch das dielektrische, elektrisch isolierende Element wird die Dielektrizitätskonstante des Materials zwischen den Kondensatorplatten $\varepsilon_r$ wesentlich bestimmt. Durch dieses Element wird das elektrische Feld des Kondensators in seiner Ausbreitung derart beeinflusst, dass die Feldstärke an der Oberfläche der Bedienblende groß genug ist, um eine Kapazitätsänderung bei Berührung zu detektieren.

Vorzugsweise ist dieses zwischen der Bedienblende und der Elektrode angeordnete dielektrische und nicht elektrisch leitende Element verformbar ausgebildet. Insbesondere ist die Verformbarkeit in Richtung einer Verbindungslinie zwischen der Bedienblende und einer Elektrode ausgebildet. Gemäß einer bevorzugten Ausführungsform ist das Element elastisch verformbar. Auf diese Weise kann das Element unter Druckspannung zwischen der Bedienblende und dem Träger der Elektrode montiert werden, so dass das Element sich flächig an die Rückseite der Bedienblende einerseits und die Elektrode andererseits anlegt.

Vorzugsweise ist das Element in direktem Kontakt mit der Unterseite der Bedienblende und der Elektrode. Neben einer möglichst kleinen Ausgestaltung kann dadurch auch die Funktionalität ohne zusätzliche Komponenten gewährleistet werden. Es ist allerdings auch möglich zwischen der Rückseite der Bedienblende und dem Element noch eine oder mehrere andere Schichten vorzusehen, beispielsweise bei einer durchsichtigen Blende eine Blendenbedruckung oder eine Folie mit Beschriftung oder Farbe.

Das Element ist vorzugsweise plattenartig ausgebildet. Auch dadurch kann somit realisiert werden, dass der Abstand zwischen der Bedienblende und der Elektrode möglichst klein ausgebildet ist und durch das dielektrische und nicht elektrisch leitende Material des Elements entsprechend gefüllt ist.

Insbesondere ist das Element aus einem dielektrischen und elektrisch isolierenden Kunststoff ausgebildet. In diesem Zusammenhang ist es besonders vorteilhaft, wenn das Element aus einem Kautschukmaterial oder einem Kautschuk aufweisenden Material ausgebildet ist. Dieses spezifische Material ermöglicht eine besonders geeignete Realisierung im Hinblick auf Bauraumminimierung einerseits, ausreichender flexibler Verformbarkeit andererseits und hoher Funktionalität im Hinblick auf die Realisierung eines Kondensators im Hinblick auf die funktionelle Ausgestaltung des kapazitiven Berührungsschalters.

Insbesondere ist das Kautschukmaterial ein Nitrilkautschuk und/oder ein Chloroprenkautschuk. Diese beiden spezifischen Kautschukmaterialien sind besonders geeignet für die Realisierung des kapazitiven Berührungsschalters.

Es kann auch vorgesehen sein, dass ein Epichlor-Hydrin-Kautschuk oder ein Fluorsilicon-Kautschuk verwendet wird.

Das Material des Elements weist vorzugsweise eine Dielektrizitätskonstante $\varepsilon_r$ größer 3, insbesondere größer 10, vorzugsweise zwischen 10 und 13, auf. Gerade dadurch kann die kapazitive Funktionalität besonders vorteilhaft erreicht werden. Derartig relativ hohe Werte einer Dielektrizitätskonstanten sind insbesondere für Materialien vorgesehen, welche keine transparenten oder transluzenten Materialien sind. Besonders relativ dünne, für den für das menschliche Auge sichtbaren Spektralbereich lichtdurchlässige Materialien weisen demgegenüber wesentlich niedrigere Dielektrizitätskonstanten auf, so dass bei diesen Materialien die Funktionalität bezüglich dem kapazitiven Wirkprinzip stark eingeschränkt ist.

Besonders vorteilhaft ist es, wenn das Material des Elements anteilig Russpartikel aufweist. Die dielektrische und elektrisch isolierende Wirkung kann dadurch nochmals verbessert werden und durch die Menge der Russpartikel exakt eingestellt werden. Gerade dann, wenn das Material des Elements Kautschuk mit einer Dielektrizitätskonstanten mit einem Wert größer 3, insbesondere zwischen 10 und 13, und beigemengten Russpartikeln ist, ist eine besonders flachbauende und mit besonders flexibler Verformbarkeit sowie besonders hoher Funktionalität im Hinblick auf die Realisierung eines Kondensators im Hinblick auf die funktionelle Ausgestaltung des kapazitiven Berührungsschalters Ausgestaltung ausgebildet.

Vorzugsweise weist das Element eine Dicke kleiner 4 cm, insbesondere zwischen 1 cm und 3,5 cm, auf. Auch bei relativ große Abständen zwischen der Elektrode und der Bedienblende kann somit auch ein kapazitiv hochfunktionelles Element überbrückend angeordnet werden.

Neben den besonders geeigneten Kautschukmaterialien können jedoch auch andere Materialien, welche dielektrisch und elektrisch isolierend sind, eingesetzt werden.

Insbesondere ist vorgesehen, dass die Bedienblende aus einem elektromagnetisch nicht dichtem Material ausgebildet ist. Insbesondere können hier Kunststoffmaterialien vorgesehen sein. Ist der Berührungsschalter für ein Haushaltsgerät zur Zubereitung von Lebensmitteln, beispielsweise einem Kochfeld, vorgesehen und ist in eine Kochplatte, welche aus Glaskeramik ausgebildet ist, integriert, so kann die Bedienblende durch das Glaskeramikmaterial gebildet sein.

Vorzugsweise ist die Dicke des dielektrischen und elektrisch nicht leitenden Elements abhängig von dem Material der Bedienblende. Dadurch können sich Ausführungen ergeben, bei denen die Dicke dieses Elements größer oder gleich oder kleiner als die Dicke der Bedienblende ist. Die Dicke des Elements ist somit durch die Konstruktion der Bedienblende vorgegeben, wobei in diesem Zusammenhang als wesentliche Parameter die Abschwächung des elektrischen Feldes, welche gerade nicht oder nicht so stark erfolgen soll, und ein entsprechender Toleranzausgleich, berücksichtigen werden müssen.

Es kann vorgesehen sein, dass die Bedienblende aus einem dielektrischen und elektrisch isolierenden Material ausgebildet ist. Insbesondere ist dann vorgesehen, dass die dielektrischen Materialien der Bedienblende und des Elements unterschiedlich sind.

Vorzugsweise ist das Element einstückig ausgebildet.

Aufgrund der Eigenschaft des Elements, nämlich der Dielektrizität und der elektrisch isolierenden Ausgestaltung, kann das Element für zumindest zwei Berührungsschalter gemeinsam verwendet werden. Aufgrund der Eigenschaften dieses Elements lassen sich somit flächige Lösungen mit einem gemeinsamen Element für mehrere oder sogar alle Berührungsschalter einer Bedieneinrichtung hinter einer Bedienblende realisieren. Dies ist bei den bekannten Ausführungen mit elektrisch leitenden Komponenten nicht möglich, da in diesem Fall alle Elektroden miteinander verbunden und somit kurzgeschlossen werden würden. Insbesondere ist das Element in Form einer Platte ausgebildet, die zwischen der Bedienblende und dem Träger der Elektroden der Berührungsschalter angeordnet ist. Diese Platte kann insbesondere auf seiner dem Träger zugewandten Seite plan ausgebildet sein oder Aussparungen für Bauteile aufweisen, die auf dem Träger angeordnet sind. Insbesondere weist die Platte einen Durchbruch oder mehrere Durchbrüche für ein oder mehrere Anzeigeelemente auf, die vorzugsweise ebenfalls auf dem Träger der Elektroden angeordnet sind. Gemäß einer bevorzugten Ausführungsform ist der Träger eine Leiterplatte, die die Bedien- und/oder Anzeigeelektronik des Haushaltsgerätes umfasst.

Es kann vorgesehen sein, dass das dielektrische und elektrisch nicht leitende Element aus transparentem oder transluzentem Material ausgebildet ist. Auf diese Weise können sich Durchbrüche für Anzeigeelemente durch das Element erübrigen, da eine Anzeige durch das Element hindurch verwirklicht werden kann.

Eine erfindungsgemäße Bedieneinrichtung für ein Hausgerät umfasst zumindest einen erfindungsgemäßen Berührungsschalter oder eine vorteilhafte Ausgestaltung davon.

Die Bedieneinrichtung ist vorzugsweise so ausgebildet, dass das dielektrisch und elektrisch isolierende Element zumindest zwei separaten Berührungsschaltern der Bedieneinrichtung zur jeweiligen Realisierung des kapazitiven Funktionsprinzips zugeordnet ist.

Bei dem Berührungsschalter und somit auch bei der Bedieneinrichtung stellen die Elektrode und der auf der Bedienoberfläche aufgesetzte oder darübergestreifte Finger eines Nutzers die Platten eines Kondensators dar. Um die relative Kapazitätsänderung bei Berührung möglichst groß ausfallen zu lassen und eine sichere Berührerkennung gewährleisten zu können, sollten die Flächen der Platten möglichst groß sein. Die Elektrodengröße lässt sich aufgrund von geometrischen Begrenzungen nicht beliebig erweitern, und die Fingergröße ist vorgegeben. Der Abstand der Platten zwischen dem Finger und der Elektrode kann durch die Erfindung möglichst klein gehalten werden und es kann erreicht werden, dass die Elektrode somit möglichst nahe an den Finger gebracht werden kann und insbesondere möglichst nahe unter die Bedienblende gesetzt werden kann.

Da in die Kapazität eines Kondensators als wesentliche Größe die Dielektrizitätszahl bzw. Dielektrizitätskonstante eingeht, kann durch die vorliegende Erfindung das dielektrische und elektrisch isolierende Element die Ausbreitung des elektrischen Felds derart begünstigen, dass die Feldstärke an der Oberfläche der Bedienblende groß genug ist, um die Kapazitätsänderung bei Berührung detektieren zu können. Dieses Koppelelement beziehungsweise dieses dielektrische und elektrisch isolierende Element kann daher im einfachsten Fall direkt auf eine Kontaktfläche der Platine beziehungsweise dem Schaltungsträger platziert werden und mit der Elektrode kontaktiert werden. Durch die Realisierung mit dem dielektrischen und elektrisch isolierenden Element wird nicht der Strom sondern das elektrische Feld weitergeleitet. Die Dielektrizitätszahl des Materials der Bedienblende geht ebenfalls, insbesondere linear, in die gesamte Dielektrizitätszahl der Kondensatoranordnung ein.

Durch die erfindungsgemäße Ausführung des Berührungsschalters und der Bedieneinrichtung kann eine kostengünstigere Realisierung im Vergleich zur Ausgestaltung einer metallischen Druckfeder erreicht werden. Darüber hinaus sind sogenannte Zwei-Komponenten-Kunststoffteile bei Blenden aus Kunststoff denkbar. Dies bedeutet, dass die Blende zusammen mit dem dielektrischen, elektrisch isolierenden Element in einem Zwei-Komponenten-Spritzgussverfahren miteinander verbunden hergestellt werden können.

Durch eine plattenartige Ausgestaltung des Elements kann diesbezüglich ein einziges Element bereitgestellt werden, welches für eine Mehrzahl von Elektroden, d.h. Sensoren und somit Berührungsschaltern als Grundlage dient und es sind somit nicht mehr viele kleine Distanzstücke erforderlich. Darüber hinaus kann eine formstabile Anbindung erreicht werden und es ist keine elektrische Verbindung zur Bedienblende und zur Oberfläche mehr gegeben, wodurch auch die Bediensicherheit erhöht werden kann, da keine galvanische Trennung mehr erforderlich ist.

In einer vorteilhaften Ausführungsform ist der Träger der Elektroden ein Touchscreen. In Form einer transparenten Platte kann das Element zwischen der Bedienblende und dem in einem Abstand hinter der Bedienblende angeordneten Touchscreen diesen Abstand zwischen der Bedienblende und dem Touchscreen überbrücken. In diesem Fall wird lediglich ein einziges Element für alle Elektroden des Touchscreens verwendet. Das Element dient als Distanzstück zwischen der Bedienblende und dem Touchscreen. Ist das Element zusätzlich elastisch ausgebildet, so können durch das Element Montagetoleranzen des Abstands von Bedienblende zu Touchscreen ausgeglichen werden. Das Element kann auch als Distanzelement für weitere Elektroden neben den Elektroden des Touchscreens ausgebildet sein.

Insbesondere kann auch vorgesehen sein, dass das Element direkt an der Unterseite der Bedienblende angebracht ist, dort insbesondere fest angebracht ist. Dadurch kann bereits beim Herstellungsprozess eine vereinfachte Fertigung gewährleistet werden, da die Bedienblende mit dem dielektrischen und elektrisch isolierenden Element quasi vorab gefertigt und hergestellt werden kann und diese fest verbunden miteinander für die weitere Montage bereitgestellt werden können. Neben einer hochpräzisen Positionierung kann dadurch auch die mechanische Stabilität erhöht werden und ein unerwünschtes Verrutschen der Komponenten relativ zueinander vermieden werden.

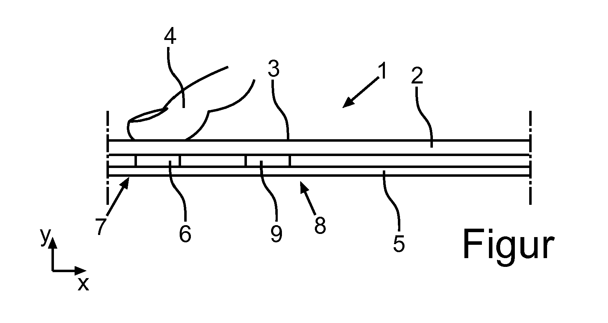

Ein Ausführungsbeispiel der Erfindung wird nachfolgend anhand einer schematischen Zeichnung näher erläutert. Die einzige Figur zeigt eine Seitenansicht einer Bedieneinrichtung 1, welche einem Hausgerät zugeordnet ist. Mittels der Bedieneinrichtung 1 können Betriebszustände des Hausgeräts eingestellt und verändert werden.

Die berührsensitiv ausgebildete Bedieneinrichtung 1 arbeitet nach dem kapazitiven Funktionsprinzip.

Die Bedieneinrichtung 1 umfasst eine Bedienblende 2 mit einer Oberfläche 3, auf der ein Finger 4 zur Betätigung der Bedieneinrichtung 1 und zum Starten oder Durchführen gewünschter Einstellungen an spezifischen Positionen aufgelegt werden kann. Unter der plattenartigen Bedienblende 2, welche aus einem elektromagnetisch nicht dichten Material ausgebildet ist, ist eine Platine beziehungsweise ein Schaltungsträger 5 angeordnet, auf dem eine Elektrode (nicht dargestellt) ausgebildet ist. Diese Elektrode und der Finger 4 bilden die Platten eines Kondensators im Hinblick auf die Funktionsrealisierung des kapazitiven Prinzips. Die Bedienblende 2 und der Schaltungsträger 5 sind beabstandet zueinander angeordnet und im Zwischenraum ist ein Element 6 angeordnet, welches aus einem dielektrischen und elektrisch isolierenden Material ausgebildet ist. An der spezifischen Stelle des Elements 6 ist durch die Bedienblende 2, den Schaltungsträger 5, insbesondere dessen Elektrode, und dem Element 6 ein Berührungsschalter 7 realisiert.

Darüber hinaus umfasst die Bedieneinrichtung 1 einen zweiten Berührungsschalter 8, welcher durch die Bedienblende 2 die Elektrode des Schaltungsträgers 5 und einem weiteren Element 9, welches aus einem dielektrischen und elektrisch isolierenden Material ausgebildet ist, realisiert.

Vorzugsweise ist vorgesehen, dass die Elemente 6 und 9 als ein einziges einstückiges Teil ausgebildet sind, so dass ein einziges dielektrisches und nicht elektrisch leitendes Element für zwei separate Berührungsschalter 7 und 8 der Bedieneinrichtung 1 zugrunde gelegt werden kann.

Gemäß der Darstellung in der Figur ist zu erkennen, dass durch die Elemente 6 und 9 und insbesondere deren Ausgestaltung ein minimaler Abstand zwischen der Elektrode und der Bedienblende 2 realisiert werden kann, so dass eine flachbauende Ausgestaltung der Bedieneinrichtung 1 realisiert werden kann.

Die Elemente 6 und 9 sind elastisch verformbar, wobei sie vorzugsweise aus einem Kautschukmaterial, beispielsweise Nitrilkautschuk oder Chloroprenkautschuk, ausgebildet sind. Die Elemente 6 und 9 sind aus Materialien aus Kautschuk, denen Russpartikel beigemengt sind ausgebildet, wobei die Dielektrizitätskonstante $\varepsilon_r$ vorzugsweise zwischen 10 und 13 beträgt. Das Material der Elemente 6 und 9 ist insbesondere nicht transparent und nicht transluzent.

Die Dicke (Erstreckung in y-Richtung) der Elemente 6 und 9 ist insbesondere abhängig von dem Material der Bedienblende 2 und ist vorzugsweise größer 1 cm.

Die Form der Elemente 6 und 9 kann bei separater Einzelstückausführung zylinderförmig oder umfangsseitig auch eckig ausgebildet sein.

## Patentansprüche

1. Kapazitiver Berührungsschalter für ein Haushaltsgerät, mit einer Bedienblende (2) zur berührsensitiven Betätigung des Berührungsschalters (7, 8) über eine Oberflächenberührung (3) der Bedienblende (2), und mit einer Elektrode, die in einem Abstand hinter der Bedienblende (2) angeordnet ist, **dadurch gekennzeichnet, dass** zwischen der Bedienblende (2) und der Elektrode ein aus einem dielektrischen und elektrisch isolierenden Material ausgebildetes Element (6, 9) angeordnet ist, welches den Abstand zwischen der Bedienblende (2) und der Elektrode überbrückt.

2. Berührungsschalter nach Anspruch 1, **dadurch gekennzeichnet, dass** das Material des Elements (6, 9) eine Dielektrizitätskonstante ($\varepsilon_r$) größer 3, insbesondere größer 10, aufweist.

3. Berührungsschalter nach Anspruch 1 oder 2, **dadurch gekennzeichnet, dass** das Material des Elements (6, 9) anteilig Russpartikel aufweist.

4. Berührungsschalter nach einem der vorhergehenden Ansprüche, **dadurch gekennzeichnet, dass** das Element (6, 9) plattenartig ausgebildet ist.

5. Berührungsschalter nach einem der vorhergehenden Ansprüche, **dadurch gekennzeichnet, dass** das Element (6, 9) aus einem dielektrischen und elektrisch isolierenden Kunststoff ausgebildet ist.

6. Berührungsschalter nach einem der vorhergehenden Ansprüche, **dadurch gekennzeichnet, dass** das Element (6, 9) aus einem Kautschukmaterial oder einem Kautschuk aufweisenden Material ausgebildet ist.

7. Berührungsschalter nach Anspruch 6, **dadurch gekennzeichnet, dass** das Kautschukmaterial ein Nitrilkautschuk und/oder ein Chloroprenkautschk und/oder ein Epichlor-Hydrin-Kautschuk und/oder ein Fluorsilicon-Kautschuk ist.

8. Berührungsschalter nach einem der vorhergehenden Ansprüche, **dadurch gekennzeichnet, dass** das Element (6, 9) eine Dicke kleiner 4 cm, insbesondere zwischen 1 cm und 3,5 cm, aufweist.

9. Berührungsschalter nach einem der vorhergehenden Ansprüche **dadurch gekennzeichnet, dass** das Element (6, 9) einstückig ausgebildet ist.

10. Berührungsschalter nach einem der vorhergehenden Ansprüche **dadurch gekennzeichnet, dass** die Bedienblende (2) und das Element (6, 9) durch Spritzgusstechnik, insbesondere Zwei-Komponenten-Spritzgusstechnik, miteinander verbunden sind.

11. Bedieneinrichtung für ein Haushaltsgerät, mit zumindest einem Berührungsschalter (7, 8) nach einem der vorhergehenden Ansprüche.

**12.** Bedieneinrichtung nach Anspruch 11, **dadurch gekennzeichnet, dass** das dielektrische und elektrisch isolierende Element (6, 9) zumindest zwei Berührungsschaltern (7, 8) der Bedieneinrichtung (1) gemeinsam zugeordnet ist.

**13.** Bedieneinrichtung nach Anspruch 12, **dadurch gekennzeichnet, dass** das Element (6, 9) allen Elektroden eines Touchscreens gemeinsam zugeordnet ist.

**14.** Bedieneinrichtung nach Anspruch 12 oder 13, **dadurch gekennzeichnet, dass** das Element (6, 9) zumindest einen Durchbruch für ein Anzeigeelement aufweist.

**15.** Haushaltsgerät mit einer Bedieneinrichtung nach einem der Ansprüche 11 bis 14.

Figur

Europäisches
Patentamt

European
Patent Office

Office européen
des brevets

**EUROPÄISCHER RECHERCHENBERICHT**

Nummer der Anmeldung

EP 09 10 0333

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | EP 1 487 105 A1 (OMRON TATEISI ELECTRONICS CO [JP]) 15. Dezember 2004 (2004-12-15) * Absatz [0026] * * Absatz [0043] - Absatz [0044] * * Abbildung 9 * ----- | 1-15 | INV. H03K17/96 ADD. H03K17/18 |
| X,P | EP 2 020 631 A2 (HOSIDEN CORP [JP]) 4. Februar 2009 (2009-02-04) * Absatz [0020] - Absatz [0043] * * Abbildungen 1-4 * ----- | 1-11,15 | |

RECHERCHIERTE SACHGEBIETE (IPC)

H03K

Der vorliegende Recherchenbericht wurde für alle Patentansprüche erstellt

| Recherchenort | Abschlußdatum der Recherche | Prüfer |
|---|---|---|
| Den Haag | 23. September 2009 | Simon, Volker |

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 09 10 0333

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

23-09-2009

| Im Recherchenbericht angeführtes Patentdokument | | Datum der Veröffentlichung | Mitglied(er) der Patentfamilie | | Datum der Veröffentlichung |
|---|---|---|---|---|---|
| EP 1487105 | A1 | 15-12-2004 | JP | 2005005058 A | 06-01-2005 |
| | | | US | 2004264150 A1 | 30-12-2004 |
| EP 2020631 | A2 | 04-02-2009 | CN | 101359907 A | 04-02-2009 |
| | | | JP | 2009037373 A | 19-02-2009 |
| | | | KR | 20090013706 A | 05-02-2009 |
| | | | US | 2009033636 A1 | 05-02-2009 |

EPO FORM P0461

Für nähere Einzelheiten zu diesem Anhang : siehe Amtsblatt des Europäischen Patentamts, Nr.12/82

**EP 2 133 997 A1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0859467 A1

- DE 102005008758 A1